# EUROPEAN PATENT SPECIFICATION

(11) **EP 4 366 480 B1**
(45) Date of publication and mention of the grant of the patent: **04.11.2026**
(21) Application number: 23207008.6
(22) Date of filing: 31.10.2023
(51) Int. Cl.: H05K 5/06

(54) **CASE WITH SCREW THREAD IN SEALED MANNER FOR COMMUNICATION EQUIPMENT**
GEHÄUSE MIT SCHRAUBENGEWINDE IN ABGEDICHTETER WEISE FÜR KOMMUNIKATIONSAUSRÜSTUNG
BOÎTIER À FILETAGE DE VIS DE MANIÈRE ÉTANCHE POUR ÉQUIPEMENT DE COMMUNICATION

(30) Priority: 02.11.2022 TW 111141913
(43) Date of publication of application: 08.05.2024
(73) Proprietor: Arcadyan Technology Corporation, Hsinchu City 30071 (TW)
(72) Inventor: Chen, Sheng Chung, 30071 Hsinchu City (TW); Chen, Ben Hong, 30071 Hsinchu City (TW); Ou, I Feng, 30071 Hsinchu City (TW)
(74) Representative: Stevens Hewlett & Perkins

(56) References cited:
- CN-A- 107 482 926
- CN-A- 109 246 958
- CN-A- 112 290 861

## Description

### CROSS-REFERENCE TO RELATED APPLICATION

### BACKGROUND OF THE INVENTION

### 1. Field of the Invention

The present invention relates generally to a case of a communication equipment, and more particularly, to a case with screw thread in sealed manner for communication equipment to prevent humidity from infiltrating.

### 2. The Prior Arts

In order to prevent outdoor communication equipment from being damaged by long time rain infiltration, the head of the screw is generally used to compress a washer tightly, or the screw is coated with sealant to achieve a waterproof effect.

However, the shell of the communication equipment needs multiple screws to be locked during assembly, which may cause the following problems: the inconvenience of disassembling and assembling a plurality of screws for each maintenance; requiring space for disposing a plurality of screws; having to use washer or sealant with the screws to ensure the waterproof effect.

CN109246958B discloses a repeater. The repeater includes a repeater enclosure, an upper cover of that repeater is arranged on the outer surface of the upper end of the repeater shell, a lower cover of the repeater is movably installed on the outer surface of the lower end of the repeater shell through internal and external threads. The middle position of the outer surface of the front end of the repeater shell is provided with a groove, the inner middle position of the groove is provided with a line fixing plate, the upper end position of the inner surface of the groove is fixedly installed with a connecting column, and one end of the connecting column is movably installed with a waterproof cover.

### SUMMARY OF THE INVENTION

A primary objective of the present invention is to provide a case with screw thread in sealed manner for communication equipment, which provides good sealing effect and waterproof effect, as well as solves the problems caused by the use of screws.

In order to achieve the aforementioned objective, the present invention provides a case with screw thread in sealed manner for communication equipment, including an upper cover and a bottom cover; the upper cover having an inner surface disposed with an internal thread, the bottom cover having an outer surface disposed with an external thread, and when the external thread being screwed to the internal thread, the inner surface of the upper cover and the outer surface of the bottom cover forming an accommodating space in a sealed state.

In a preferred embodiment, the upper cover includes a first side wall, a connecting wall, and a second side wall, the inner surface of the first side wall has internal threads, and the connecting wall is connected between the first side wall and the second side wall and extends radially; wherein the bottom cover includes an outer side wall and a base, the outer side wall is arranged on a top surface of the base along a circumference and the outer surface of the outer side wall has external threads; and wherein when the outer thread is screwed to the internal thread, the inner surface of the first side wall of the upper cover and the outer surface of the outer side wall of the bottom cover are in a sealed state.

In a preferred embodiment, the case further includes a washer disposed between the inner surface of the connecting wall of the upper cover and a top surface of the outer side wall of the bottom cover.

In a preferred embodiment, the washer includes a first ring portion and a second ring portion, a top surface of the first ring portion abuts against a bottom surface of the connecting wall of the upper cover, and a bottom surface of the first ring portion abuts against the top surface of the outer side wall of the bottom cover; the second ring portion protrudes from the bottom surface of the first ring portion, and an outer surface of the second ring portion abuts against an inner surface of the outer side wall of the bottom cover.

In a preferred embodiment, the inner surface of the first side wall of the upper cover has a marking portion, the marking portion is located below the internal thread and is used to mark a locking tightness of the bottom cover.

In a preferred embodiment, the marking portion is a groove or rib extending axially, a row of characters or numbers or patterns arranged axially.

In a preferred embodiment, the base has a bottom surface with an indicating portion, and the indicating portion points to the marking portion.

In a preferred embodiment, a printed circuit board is installed in the accommodating space.

**In** a preferred embodiment, the case further includes a support base, the support base is located below the upper cover and a gap is formed between an outer side wall of the support base and the upper cover, and the bottom cover is disposed on the support base.

**In** a preferred embodiment, the case further includes an anti-loose glue, and the anti-loose glue is coated between the internal thread and the external thread.

The case of the present invention fixes the bottom cover to the upper cover by screwing the external thread to the internal thread, which has the following advantages: quickly and repeated assembly and disassembly; no need for any space for bolts so as to minimizes the size; without bolt, no need for washers or sealant; good sealing properties and good waterproof effect so as to prevent water from entering the case. The invention is defined by the independent claim 1.

### BRIEF DESCRIPTION OF THE DRAWINGS

The present invention will be apparent to those skilled in the art by reading the following detailed description of a preferred embodiment thereof, with reference to the attached drawings, in which:
FIG. 1 is a perspective view of a case with screw thread in sealed manner for communication equipment of the present invention;
FIG. 2 is an exploded view of a case with screw thread in sealed manner for communication equipment of the present invention;
FIG. 3 is a partial cross-sectional view of a case with screw thread in sealed manner for communication equipment of the present invention;
FIG. 4 is an enlarged schematic view of area IV of FIG. 3;
FIG. 5 is a perspective view of the present invention with the support base removed, wherein the inner surface of the first side wall of the upper cover has a marking portion, and the bottom surface of the base has an indicating portion; and
FIG. 6 is a cross-sectional view of a printed circuit board vertically placed in the accommodating space of the present invention.

### DETAILED DESCRIPTION OF THE PREFERRED EMBODIMENT

The accompanying drawings are included to provide a further understanding of the invention, and are incorporated in and constitute a part of this specification. The drawings illustrate embodiments of the invention and, together with the description, serve to explain the principles of the invention.

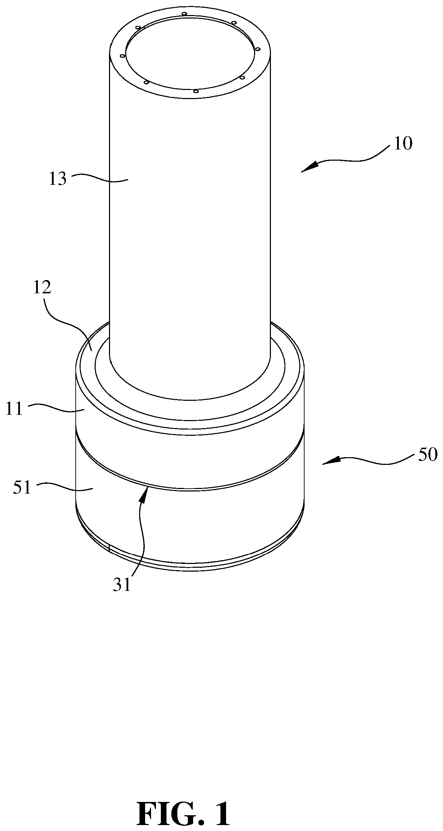

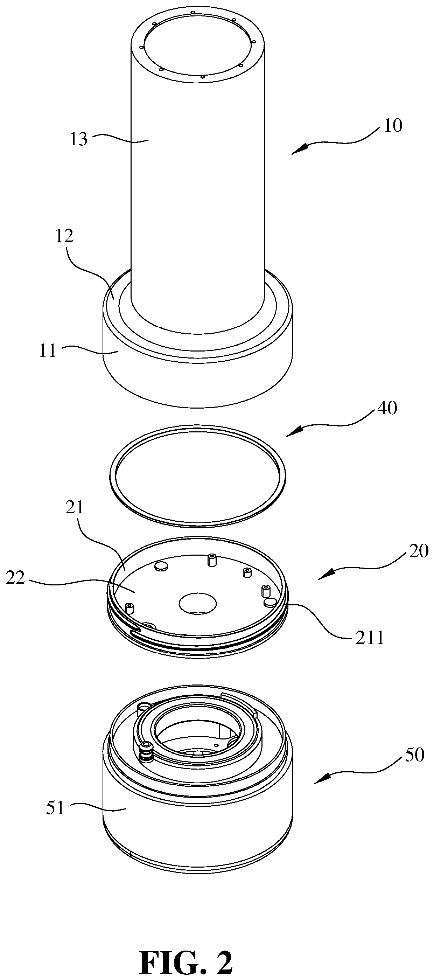

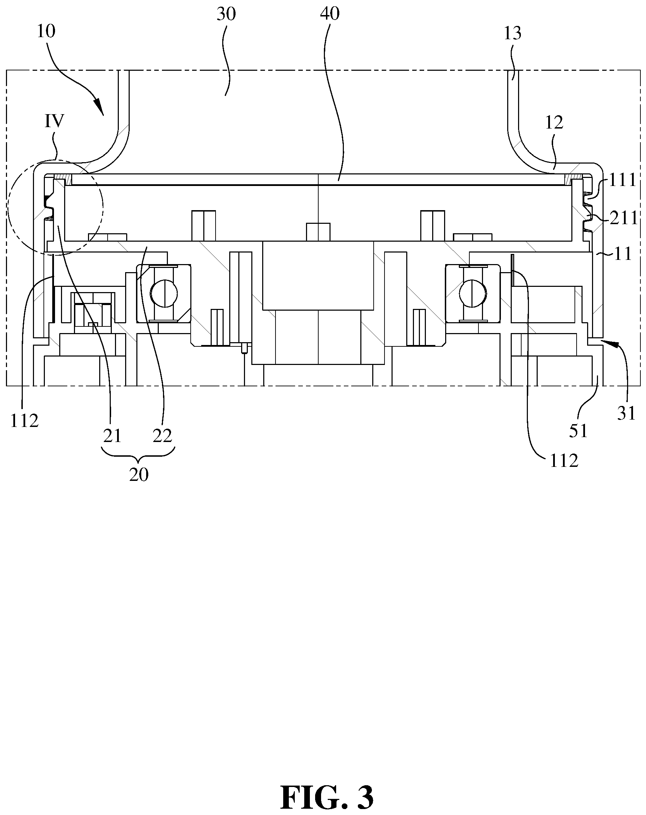

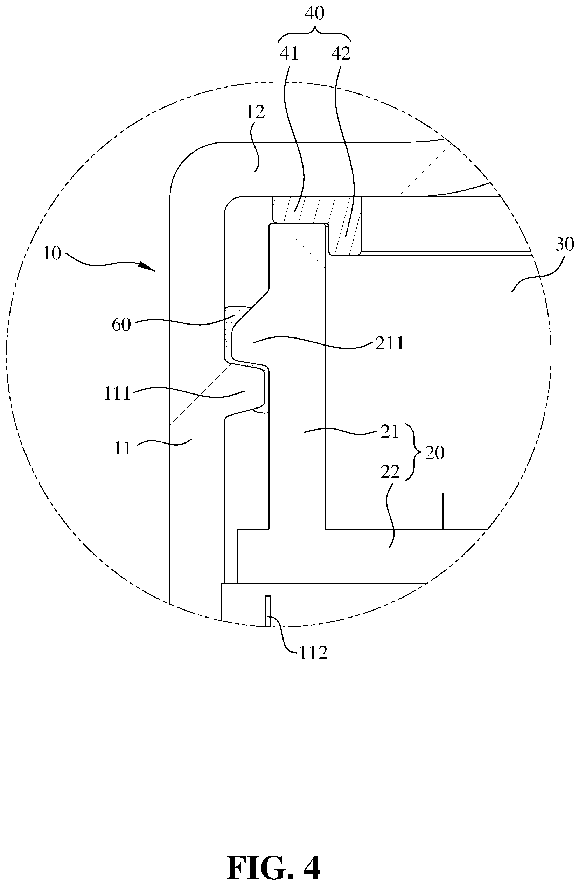

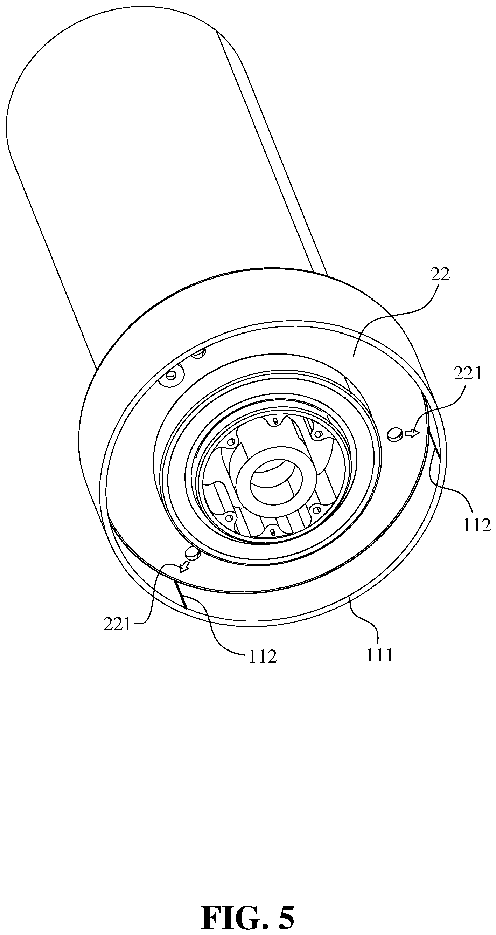

FIG. 1 is a perspective view of a case with screw thread in sealed manner for communication equipment of the present invention; FIG. 2 is an exploded view of a case with screw thread in sealed manner for communication equipment of the present invention; FIG. 3 is a partial cross-sectional view of a case with screw thread in sealed manner for communication equipment of the present invention; FIG. 4 is an enlarged schematic view of area IV of FIG. 3; and FIG. 5 is a perspective view of the present invention with the support base 50 removed, wherein the inner surface of the first side wall 11 of the upper cover 10 has a marking portion 112, and the bottom surface of the base 22 has an indicating portion 221. As shown in FIG. 1 to FIG. 5, the present invention provides a case with screw thread in sealed manner for communication equipment, which includes an upper cover 10 and a bottom cover 20. The upper cover 10 includes a first side wall 11, a connecting wall 12, and a second side wall 13, and the first side wall 11 has an upper part and a lower part. The upper part of the inner surface of the first side wall 11 has an internal thread 111, the connecting wall 12 is connected between the first side wall 11 and the second side wall 13, and the connecting wall 12 extends radially. The bottom cover 20 includes an outer side wall 21 and a base 22. The outer side wall 21 is disposed on the top surface of the base 22 around a circumference and has external threads 211 on the outer surface. The external thread 211 is screwed to the internal thread 111, so that the inner surface of the first side wall 11 of the upper cover 10 and the outer surface of the outer side wall 21 of the bottom cover 20 are in a sealed state. Also, the upper cover 10 and the bottom cover 20 together form an accommodating space 30. In a preferred embodiment, the external thread 211 and the internal thread 111 can be one circle.

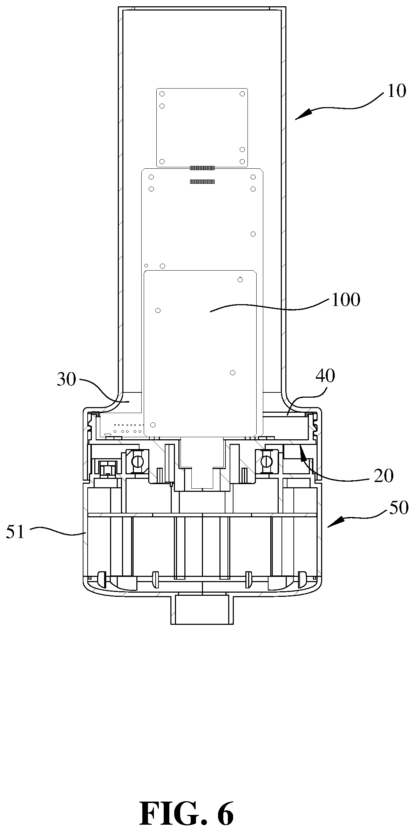

FIG. 6 is a cross-sectional view of the printed circuit board 100 vertically placed in the accommodating space 30 of the present invention. As shown in FIG. 6, and also refer to FIG. 4, the printed circuit board 100 of the communication equipment is vertically placed in the accommodating space 30. Because the internal thread 111 and the external thread 211 are tightly fit, the inner surface of the upper part of the first side wall 11 of the upper cover 10 and the outer surface of the outer side wall 21 of the bottom cover 20 are in a sealed state, and moisture or humidity cannot pass through the contact between the inner surface of the upper part of the first side wall 11 of the upper cover 10 and the outer surface of the outer side wall 21 of the bottom cover 20 to enter the accommodation space 30. As such, the components on the printed circuit board 100 is prevented from being affected by moisture and rusted.

As shown in FIGS. 1-4, in a preferred embodiment, the case of the present invention further includes a washer 40, and the washer 40 is arranged between the inner surface of the connecting wall 12 of the upper cover 10 and the top surface of the outer side wall 21 of the bottom cover 20. More specifically, when the external thread 211 is screwed to the internal thread 111, the bottom cover 20 will move upward, and the connecting wall 12 of the upper cover 10 and the outer side wall 21 of the bottom cover 20 will jointly press the washer 40, so that the washer 40 can completely seal any gap between the inner surface of the connecting wall 12 of the upper cover 10 and the top surface of the outer side wall 21 of the bottom cover 20 to prevent humidity from passing through the contact between the inner surface of the connecting wall 12 of the upper cover 10 and the top surface of the outer side wall 21 of the bottom cover 20 to enter the accommodating space 30.

Preferably, the washer 40 includes a first ring portion 41 and a second ring portion 42, the top surface of the first ring portion 41 abuts against the bottom surface of the connecting wall 12 of the upper cover 10, the bottom surface of the first ring portion 41 abuts against the top surface of the outer side wall 21 of the bottom cover 20; the second ring portion 42 protrudes from the bottom surface of the first ring portion 41, and the outer surface of the second ring portion 42 abuts against the inner surface of the outer side wall 21 of the bottom cover 20. Thereby, before the external thread 211 is screwed to the internal thread 111, the washer 40 can be firmly positioned on the top surface of the outer side wall 21 of the bottom cover 20, and the bottom cover 20 will move upward in the process of screwing the external thread 211 to the internal thread 111 so that the washer 40 will not fall off from the top surface of the outer side wall 21 of the bottom cover 20. Moreover, in the process of screwing the external thread 211 to the internal thread 111, the bottom cover 20 will move upwards, and the connecting wall 12 of the upper cover 10 and the outer side wall 21 of the bottom cover 20 will jointly press the first ring portion 41, so that the second ring portion 41 can completely seal the gap between the inner surface of the connecting wall 12 of the upper cover 10 and the top surface of the outer side wall 21 of the bottom cover 20, preventing moisture from passing through the contact between the inner surface of the connecting wall 12 of the upper cover 10 and the top surfaces of the outer side wall 21 of the bottom cover 20 to enter the accommodating space 30.

As shown in FIG. 3, FIG. 4, and FIG. 5, in a preferred embodiment, the inner surface of the lower part of the first side wall 11 of the upper cover 10 has two marking portions 112, and these marking portions 112 are located below the internal thread 111 and are used to indicate the locking tightness of the bottom cover 20. More specifically, the degree of locking tightness of the bottom cover 20 is positively correlated with the tightness of the washer 40, and the tightness of the washer 40 is positively correlated with the waterproof effect of the washer. In other words, the higher degree the locking tightness of the bottom cover 20 is, the tighter the washer 40 is and the better the waterproof effect of the washer 40 will be. On the other hand, the lower degree the locking tightness of the bottom cover 20 is, the lower the tightness of the washer 40 is, and the worse the waterproof effect of the washer 40 will be. When the external thread 211 is screwed to the internal thread 111, the bottom cover 20 will move upwards, and the marking portions 112 will gradually appear, and the user can clearly see the marking portions 112 and judge the degree of locking tightness of the bottom cover 20. The user then knows the degree of locking tightness and waterproof effect of the washer 40, and can also prevent the locking of the bottom cover 20 from being too loose or too tight.

As shown in FIG. 5, in a preferred embodiment, each marking portion 112 is a groove, and the groove extends axially. When the external thread 211 is screwed to the internal thread 111, the bottom cover 20 will move upwards, and the groove will gradually appear; the longer the groove appears, the higher degree the locking tightness of the bottom cover 20 and the tightness of the washer 40 are, as well as the better the waterproof effect will be. On the other hand, the shorter the length of the groove, the lower degree the locking tightness of the bottom cover 20 and the tightness of the washer 40 are, as well as the worse the waterproof effect will be. Therefore, the user can judge the locking tightness of the bottom cover 20 according to the length of the groove, and then know the tightness and waterproof effect achieved by the washer 40.

In some embodiments, each marking portion 112 may be axially extending ribs, axially arranged characters, numbers, or patterns, and all of which have the effect of judging the locking tightness of the bottom cover 20, but the present invention is not limited thereto.

As shown in FIG. 5, in a preferred embodiment, the bottom surface of the base 22 has two indicating portions 221, and the indicating portions 221 point to the marking portions 112, respectively. Accordingly, the indicating portions 221 can remind the user to pay attention to the positions and display conditions of the marking portions 112. Preferably, each indicating portion 221 is an arrow, but the present invention is not limited thereto.

As shown in FIGS. 1-3, the case of the present invention further includes a support base 50, the support base 50 is located below the upper cover 10, a gap 31 is formed between an outer side wall 51 of the support base 50 and the first side wall 11 of the upper cover 10, and the bottom cover 20 is disposed on the support base 50. Furthermore, there are two possible paths that the humidity may infiltrate the case of the present invention: the first possible path is through the gap 31 between the outer side wall 51 of the support base 50 and the first side wall 11 of the upper cover 10, and the other is from below the support base 50 to penetrates into the support base 50. The first path is mainly blocked by the engagement of the internal thread 111 and the external thread 211 and by the washer 40. The second path is blocked by the support base 50. In other words, the engagement of the internal thread 111 and the external thread 211, the washer 40, and the support base 50 can completely prevent humidity and moisture from infiltrating the accommodating space 30 through two possible paths, and achieve excellent waterproof effect.

As shown in FIG. 4, in a preferred embodiment, the case of the present invention further includes an anti-loose glue 60, and the anti-loose glue 60 is coated between the internal thread 111 and the external thread 211. Accordingly, the anti-loose glue 60 can not only prevent the internal thread 111 and the external thread 211 from being loosened by the vibration force, but also fills the gap between the internal thread 111 and the external thread 211, increases the sealing between the inner surface of the upper part of the first side wall 11 of the upper cover 10 and the outer surface of the outer side wall 21 of the bottom cover 20, improves the waterproof effect, and provides lubricity to achieve a controlled torque when the outer thread 211 is screwed to engage the inner thread 111.

In summary, the case of the present invention fixes the bottom cover 20 to the upper cover 10 by screwing the external thread 211 to the internal thread 111, and has the following advantages: quickly and repeated assembly and disassembly; no need for any space for bolts so as to minimizes the size; without bolt, no need for washers or sealant; good sealing properties and good waterproof effect so as to prevent water from entering the case.

Although the present invention has been described with reference to the preferred embodiments thereof, it is apparent to those skilled in the art that a variety of modifications and changes may be made without departing from the scope of the present invention which is intended to be defined by the appended claims.

## Claims

1. A case with screw thread in sealed manner for communication equipment, comprising:
an upper cover (10), having an inner surface disposed with an internal thread (111), wherein the upper cover includes a first side wall (11), a connecting wall (12), and a second side wall (13), and the connecting wall is connected between the first side wall and the second side wall and extends radially;
a bottom cover (20), having an outer surface disposed with an external thread (211), wherein the bottom cover includes an outer side wall (21) and a base (22) and the outer side wall is arranged on a top surface of the base along a circumference, the case **characterized by** having
a washer (40) disposed between the inner surface of the connecting wall (12) of the upper cover (10) and a top surface of the outer side wall (21) of the bottom cover (20), wherein the washer is in the upper cover (10);
wherein the external thread (211) is screwed to the internal thread (111) and the inner surface of the upper cover (10) surrounds and covers the outer surface of the bottom cover (20) for forming an accommodating space (30) in a sealed state,
wherein the inner surface of the first side wall (11) of the upper cover (10) has a marking portion ((221), the marking portion is located below the internal thread (111) and is used to mark a locking tightness of the bottom cover (20).

2. The case with screw thread in sealed manner for communication equipment according to claim 1, wherein when the outer thread (211) is screwed to the internal thread (111), the inner surface of the first side wall (11) of the upper cover (10) and the outer surface of the outer side wall (21) of the bottom cover (20) are in a sealed state.

3. The case with screw thread in sealed manner for communication equipment according to claim 1, wherein the washer (40) includes a first ring portion and a second ring portion, a top surface of the first ring portion abuts against a bottom surface of the connecting wall (12) of the upper cover (10), and a bottom surface of the first ring portion abuts against the top surface of the outer side wall (21) of the bottom cover (20); the second ring portion protrudes from the bottom surface of the first ring portion, and an outer surface of the second ring portion abuts against an inner surface of the outer side wall (21) of the bottom cover (20).

4. The case with screw thread in sealed manner for communication equipment according to claim 1, wherein the marking portion (221) is a groove or rib extending axially, a row of characters or numbers or patterns arranged axially.

5. The case with screw thread in sealed manner for communication equipment according to claim 1, wherein the base (22) has a bottom surface with an indicating portion, and the indicating portion points to the marking portion (221).

6. The case with screw thread in sealed manner for communication equipment according to claim 1, wherein a printed circuit board is installed in the accommodating space (30).

7. The case with screw thread in sealed manner for communication equipment according to claim 1, further comprising a support base, the support base being located below the upper cover (10), a gap being formed between an outer side wall (21) of the support base and the upper cover, and the bottom cover (20) being disposed on the support base.

8. The case with screw thread in sealed manner for communication equipment according to claim 1, further comprising an anti-loose glue, and the anti-loose glue being coated between the internal thread (111) and the external thread (211).

## Patentansprüche

1. Ein abgedichtetes Gehäuse mit Schraubgewinde für Kommunikationsgeräte, umfassend:
eine obere Abdeckung (10) mit einer Innenfläche, die mit einem Innengewinde (111) versehen ist, wobei die obere Abdeckung eine erste Seitenwand (11), eine Verbindungswand (12) und eine zweite Seitenwand (13) umfasst und die Verbindungswand zwischen der ersten Seiten-wand und der zweiten Seitenwand angeordnet ist und sich radial erstreckt;
einen Unterdeckel (20) mit einer Außenfläche, die mit einem Außengewinde (211) versehen ist, wobei der Unterdeckel eine äußere Seitenwand (21) und einen Boden (22) umfasst und die äußere Seitenwand entlang eines Umfangs auf einer Oberseite des Bodens angeordnet ist,
wobei das Gehäuse **dadurch gekennzeichnet ist, dass** eine Unterlegscheibe (40) zwischen der Innenfläche der Verbindungswand (12) der oberen Abdeckung (10) und einer Oberseite der äußeren Seitenwand (21) der unteren Abdeckung (20) angeordnet ist, wobei sich die Unterleg-scheibe in der oberen Abdeckung (10) befindet;
wobei das Außengewinde (211) in das Innengewinde (111) eingeschraubt ist und die Innenfläche des oberen Deckels (10) die Außenfläche des unteren Deckels (20) umgibt und abdeckt, um einen Aufnahmeraum (30) in einem abgedichteten Zustand zu bilden,
wobei die Innenfläche der ersten Seitenwand (11) der oberen Abdeckung (10) einen Markierungsabschnitt (221) aufweist, der sich unterhalb des Innengewindes (111) befindet und zur Markierung der Verriegelungsfestigkeit der unteren Abdeckung (20) dient.

2. Gehäuse mit dichtendem Schraubgewinde für Kommunikationsgeräte nach Anspruch 1, wobei, wenn das Außengewinde (211) in das Innengewinde (111) eingeschraubt ist, die die Innenfläche der ersten Seitenwand (11) der oberen Abdeckung (10) und die Außen-fläche der äußeren Seitenwand (21) der unteren Abdeckung (20) in einem abgedichteten Zustand sind.

3. Gehäuse mit dichtendem Gewinde für Kommunikationsgeräte gemäß Anspruch 1, wobei die Unterlegscheibe (40) einen ersten Ringabschnitt und einen zweiten Ringabschnitt umfasst, eine Oberseite des ersten Ringabschnitts an einer Unterseite der Verbindungswand (12) der oberen Abdeckung (10) anliegt und eine Unterseite des ersten Ringabschnitts an der Oberseite der äußeren Seitenwand (21) der unteren Abdeckung (20); der zweite Ringabschnitt ragt von der Unterseite des ersten Ringabschnitts hervor, und eine Außenfläche des zweiten Ringabschnitts liegt an einer Innenfläche der äußeren Seitenwand (21) der unteren Abdeckung (20) an.

4. Das abgedichtete Gehäuse mit Schraubgewinde für Kommunikationsgeräte nach Anspruch 1, wobei der Markierungsabschnitt (221) eine sich axial erstreckende Nut oder Rippe, eine axial angeordnete Reihe von Zeichen, Zahlen oder Mustern ist.

5. Gehäuse mit dichtendem Gewinde für Kommunikationsgeräte gemäß Anspruch 1, wobei der Sockel (22) eine Unterseite mit einem Anzeigebereich aufweist und der Anzeigebereich auf den Markierungsabschnitt (221) zeigt.

6. Gehäuse mit dichtendem Schraubgewinde für Kommunikationsgeräte gemäß Anspruch 1, wobei eine Leiterplatte in dem Aufnahmeraum (30) eingebaut ist.

7. Gehäuse mit abgedichtetem Schraubgewinde für Kommunikationsgeräte nach Anspruch 1, das ferner eine Stützbasis umfasst, wobei sich die Stützbasis unterhalb der oberen Abdeckung (10) befindet, zwischen einer äußeren Seitenwand (21) der Stützbasis und der oberen Abdeckung ein Spalt gebildet ist und die untere Abdeckung (20) auf der Stützbasis angeordnet ist.

8. Gehäuse mit abgedichtetem Gewinde für Kommunikationsgeräte gemäß Anspruch 1, das ferner einen Klebstoff gegen Lösen umfasst, wobei der Klebstoff gegen Lösen zwischen dem Innengewinde (111) und dem Außengewinde (211) aufgetragen ist.

## Revendications

1. Boîtier à vissage étanche destiné à un équipement de communication, comprenant:
un couvercle supérieur (10), dont la surface intérieure est pourvue d'un filetage interne (111), dans lequel le couvercle supérieur comprend une première paroi latérale (11), une paroi de raccor-dement (12) et une deuxième paroi latérale (13), et la paroi de raccordement est reliée entre la première paroi latérale et la deuxième paroi latérale et s'étend radialement;
un couvercle inférieur (20), dont la surface extérieure est pourvue d'un filetage externe (211), dans lequel le couvercle inférieur comprend une paroi latérale extérieure (21) et une base (22), et la paroi latérale extérieure est disposée sur une surface supérieure de la base le long d'une circonférence,
le boîtier étant **caractérisé en ce qu'**il comporte une rondelle (40) disposée entre la surface intérieure de la paroi de liaison (12) du couvercle supérieur (10) et une surface supérieure de la paroi latérale extérieure (21) du couvercle inférieur (20), la rondelle se trouvant dans le couvercle supérieur (10);
le filetage extérieur (211) étant vissé sur le filetage intérieur (111), et la surface intérieure du couvercle supérieur (10) entourant et recouvrant la surface extérieure du cou-vercle inférieur (20) afin de former un espace de logement (30) dans un état étanche,
dans lequel la surface intérieure de la première paroi latérale (11) du couvercle supérieur (10) comporte une partie de repérage (221), ladite partie de repérage étant située en dessous du filetage interne (111) et servant à indiquer le niveau de serrage du cou-vercle inférieur (20).

2. Boîtier à filetage vissé de manière étanche pour équipement de communication selon la revendication 1, dans lequel, lorsque le filetage extérieur (211) est vissé sur le filetage intérieur (111), la surface intérieure de la première paroi latérale (11) du couvercle supérieur (10) et la surface extérieure de la paroi latérale extérieure (21) du couvercle inférieur (20) se trouvent dans un état étanche.

3. Boîtier à filetage étanche pour équipement de communication selon la revendication 1, dans lequel la rondelle (40) comprend une première partie annulaire et une deuxième partie annulaire, une surface supérieure de la première partie annulaire vient en butée contre une surface inférieure de la paroi de raccordement (12) du couvercle supérieur (10), et une surface inférieure de la première partie annulaire vient en butée contre la surface supérieure de la paroi latérale extérieure (21) du couvercle inférieur (20); la deuxième partie annulaire fait saillie depuis la surface inférieure de la première partie annulaire, et une surface extérieure de la deuxième partie annulaire vient en butée contre une surface intérieure de la paroi latérale extérieure (21) du couvercle inférieur (20).

4. Boîtier à filetage étanche pour équipement de communication selon la revendication 1, dans lequel la partie de marquage (221) est une rainure ou une nervure s'étendant axialement, une rangée de caractères, de chiffres ou de motifs disposés axialement.

5. Boîtier à filetage étanche pour équipement de communication selon la revendication 1, dans lequel la base (22) présente une surface inférieure comportant une partie indicatrice, et ladite partie indicatrice pointe vers la partie de marquage (221).

6. Boîtier à filetage étanche pour équipement de communication selon la revendication 1, dans lequel une carte de circuit imprimé est installée dans l'espace de logement (30).

7. Boîtier à filetage étanche pour équipement de communication selon la revendication 1, comprenant en outre une base de support, la base de support étant située sous le couvercle supérieur (10), un espace étant formé entre une paroi latérale extérieure (21) de la base de support et le couvercle supérieur, et le couvercle inférieur (20) étant disposé sur la base de support.

8. Boîtier à filetage étanche pour équipement de communication selon la revendication 1, comprenant en outre une colle anti-desserrage, ladite colle anti-desserrage étant appliquée entre le filetage interne (111) et le filetage externe (211).
